(19) Europäisches Patentamt
European Patent Office
Office européen des brevets

(11) EP 2 899 886 B1

(12) EUROPEAN PATENT SPECIFICATION

(45) Date of publication and mention of the grant of the patent:
**19.07.2017 Bulletin 2017/29**

(51) Int Cl.:
*H03K 17/082* (2006.01)     *H02M 1/32* (2007.01)
*H02M 1/38* (2007.01)     *H02M 1/00* (2007.01)

(21) Application number: **14194605.3**

(22) Date of filing: **24.11.2014**

(54) **Semiconductor drive device and power conversion device using the same**

Halbleiterantriebsvorrichtung und Spannungsumwandlungsvorrichtung damit

Dispositif semi-conducteur et dispositif de conversion de puissance l'utilisant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.01.2014 JP 2014009124**

(43) Date of publication of application:
**29.07.2015 Bulletin 2015/31**

(73) Proprietor: **Hitachi, Ltd.**
**Tokyo (JP)**

(72) Inventors:
• **Onda, Kohei**
**Chiyoda-ku, Tokyo 100-8280 (JP)**
• **Sakano, Junichi**
**Chiyoda-ku, Tokyo 100-8280 (JP)**
• **Kouno, Yasuhiko**
**Chiyoda-ku, Tokyo 100-8280 (JP)**
• **Ishikawa, Katsumi**
**Chiyoda-ku, Tokyo 100-8280 (JP)**

(74) Representative: **Moore, Graeme Patrick et al**
**Mewburn Ellis LLP**
**City Tower**
**40 Basinghall Street**
**London EC2V 5DE (GB)**

(56) References cited:
EP-A1- 2 458 736     WO-A2-2009/118201
JP-A- 2002 084 173     US-A1- 2012 013 370

**Description**

BACKGROUND OF THE INVENTION

1. Field of the Invention

The present invention relates to a semiconductor drive device equipped with a protection function, and a power conversion device using the semiconductor drive device.

2. Description of the Related Art

The power conversion devices including an inverter realize power conversion by switching operation of a semiconductor switching elements. As typical examples of the semiconductor switching elements, voltage driven semiconductor elements including a MOS-FET and an IGBT have been extensively employed. In particular, IGBT that enables high-speed switching and can control a large amount of power has been used in extensive fields from a small capacity inverter for home appliances to a large capacity inverter for railway, etc.

In order to control the semiconductor switching element of this type, the semiconductor drive device is required. In general, a drive device for the voltage driven semiconductor has a function of controlling a conductive state of the element with the application of a voltage to the semiconductor switching element.

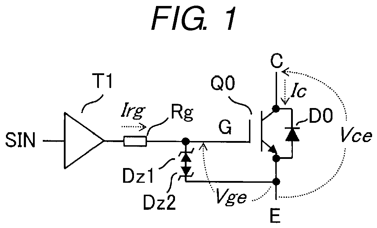

FIG. 1 illustrates an example of a typical gate driver configuration of an IGBT drive device. An appropriate voltage is applied to a gate G of an IGBT Q0 by a output stage circuit T1 on the basis of a drive command input signal SIN to control a collector current Ic conducting between a collector C and an emitter E of the IGBT Q0.

In this example, a gate resistor Rg limits a current Irg flowing in a gate G to regulate a change ratio in the voltage Vge between the gate G and the emitter E. With this regulation, a switching speed of the IGBT Q0, that is, a change ratio of the collector current Ic, and a change ratio in a voltage Vce between the collector C and the emitter E can be appropriately defined. FIG. 1 illustrates an example of the configuration of an IGBT module having a diode D0 in reverse parallel to the IGBT Q0 for the purpose of allowing a circulation current to flow.

When the semiconductor switching element is used for an inverter, in order to prevent an element damage attributable to arm short circuit or load short circuit, the semiconductor switching drive device frequently has a short-circuit protection function. The arm short circuit represents a phenomenon that plural semiconductor switching elements are connected in series between positive and negative power supply lines turn on at the same time to short-circuit between positive and negative of the power supply. Also, the load short-circuit represents a phenomenon that a load connected to the inverter is short-circuited, and the positive and negative of the power supply are short-circuited through the semiconductor switching element that is in an on-state. When those short circuits are generated, an excessive current flows into the semiconductor switching element, resulting in a destruction of the semiconductor switching element.

The above short-circuits are generally classified into three short-circuit modes depending on a conductive state of a semiconductor module when the short circuit occurs (Jorg Schumann, et al., "Influence of the Gate Drive on the Short-Circuit Type II and Type III Behavior of HV-IGBT", PCIM2010, pp.709-714).

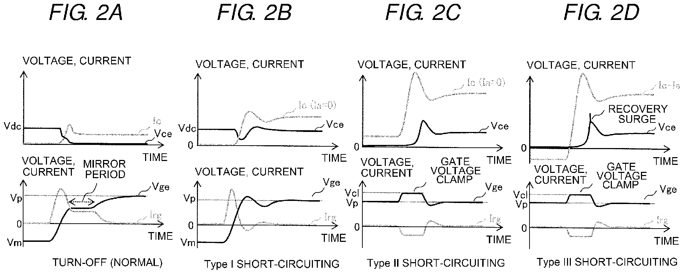

Hereinafter, a description will be given of features of those three short circuit modes with reference to current and voltage waveforms of the IGBT module illustrated in FIGS. 2A to 2D. FIGS. 2A to 2D are diagrams illustrating current and voltage waveforms in a turn-on state which is a normal state, in a short circuit state of Type I, in a short circuit state of Type II, and in a short circuit state of Type III, respectively.

In the short circuit of Type I, a short circuit occurs when a subject arm element turns on. As an example, when upper and lower arms of the inverter are considered, a pair of arm elements is destroyed during a turn-off, and remains in the conductive state, and the short circuit occurs in a status where the subject arm turns on in that state. The current and voltage waveforms of the subject arm element in this situation are illustrated in FIG. 2B.

In a normal turn-on state of FIG. 2A, when a gate-emitter voltage Vge increases from Vm toward Vp to transition to an on-state, a collector current Ic increases. On the other hand, a collector-emitter voltage Vce drops from a supply voltage Vdc to an on-voltage (several V).

On the contrary, in the short circuit of Type I, the collector current Ic increases to a saturated current of the IGBT due to the short circuit whereas the collect-emitter voltage Vce does not decrease to the on-voltage (several V). In this situation, a displacement current Is of (Ex. 1) flows into the gate from the collector through a feedback capacitor Cgc.

$$Is = Cgc \times dVce/dt \quad \dots \quad (Ex.\ 1)$$

For that reason, the gate voltage Vge increases to about the supply voltage. As a result, a mirror period (FIG.

2A) of the gate voltage Vge found in the normal turn-on state is eliminated.

Subsequently, the short circuit of Type II will be described with reference to FIG. 2C.

In the short circuit of Type II, the subject arm IGBT is in a gate-on state, the short circuit occurs when the collector current Ic flows. As an example, the paired arm elements that are in an off-state may be suddenly destroyed and short-circuited in a period where the IGBT of the subject arm is conducting.

In the short circuit of Type II, because the arm elements are short-circuited in the gate-on state, a current change rate dIc/dt of the arm elements is larger than that in the short circuit of Type I limited by the element characteristics, and given by a parasitic inductance Le of a main circuit through (Ex. 2).

$$dIc/dt \approx Vdc/Le \; \dots \; (Ex. \; 2)$$

As a result, the collector current Ic rapidly increases, and the short circuit of Type II becomes more intense than the short circuit of Type I. Further, when a current flows into the gate by (Ex. 1), a gate voltage increases, and the saturated current further increases. For that reason, in order to reduce overvoltage breakdown of the gate and the saturated current, it is general to provide a voltage clamp element (series circuit of Dz1 and Dz2) between the gate and the emitter illustrated in FIG. 1. With this element, as illustrated in FIG. 2C, the gate-emitter voltage Vge is clamped to a certain specific value Vcl.

Finally, the short circuit of Type III will be described with reference to FIG. 2D.

The short circuit of Type III is a mode in which the IGBT of the subject arm is short-circuited in the gate-on state as in the short circuit of Type II, but is different from the short circuit of Type II in that the subject arm is short-circuited in a state where not IGBT but diodes connected in reverse parallel to each other are conducting.

As an example, there is a case in which the paired arm elements that are in the off-state are suddenly destroyed and short-circuited in a state where the diode of the subject arm allows the circulation current to flow, and the gate of the IGBT of the subject arm is on. Therefore, when it is assumed that an anode current in the diode of the subject arm is Ia, the short circuit occurs in a state where a terminal current Ic-Ia of the IGBT module is negative. Similarly, in this case, because the short circuit occurs in the gate-on state, the current change rate dIc/dt becomes larger as with the short circuit of Type II. Therefore, the short circuit of Type III becomes intense. Also, higher-speed protection is required because when the diode voltage rapidly increases, hard recovery occurs, and a surge voltage (recovery surge in the figure) occurs.

When the short circuit occurs due to the destruction of the paired arm element or breakthrough, in order to protect the subject arm element from a secondary damage, it is desirable to provide a short-circuit protection circuit in the semiconductor drive device. In general, the short-circuit protection circuit is configured to limit or cut off a current in the semiconductor switching element to protect the element when the current and the voltage of the semiconductor switching element are observed, and exceed predetermined values.

For example, in the case of the IGBT, as means for detecting the short circuit state, there are proposed a method of monitoring the voltage of the collector, a method of monitoring a collector current value or an emitter current value with the use of a current transformer, a sense resistor, or a sense IGBT, a method of monitoring an electromotive force generated in a parasitic inductance of the IGBT module, or a collector current value or an emitter current value calculated from the electromotive force, and a method of monitoring the gate voltage or the gate current.

An adaptability of typical detection systems to the above three short circuit modes will be described with reference to Table 1 with the IGBT as an example.

Table 1

|  | Type I short-circuit compatibility | Types II, III short-circuit compatibility |
| --- | --- | --- |
| Collector/emitter current detection | good | good |
| Collector voltage Detection | good | normal |
| Gate voltage detection (mirror determination type) | good | bad |
| Gate voltage detection (overvoltage determination type) | normal | good |
| Gate current detection (negative current determination) | normal | good |

The collector current or emitter current detection system can deal with the three modes because an overcurrent state generated in the short circuit can be detected directly and fast.

On the contrary, the collector voltage detection system determines that the collector-emitter voltage is high in spite of the on-state, and detects the short circuit. In general, this detection system has a feature that a detection delay is larger than that in the collector current or emitter current detection system.

For example, when the collector current Ic and the collector-emitter voltage Vce are compared between FIGS. 2B and 2C, an increase in Vce in the short circuit state is delayed more than a timing at which Ic increases. This is because an increase ΔVce in the collector-emitter voltage in the short circuit state rapidly increases in a period of dIc/dt<0 according to (Ex. 3).

$$\Delta Vce = -Le \cdot dIc/dt \quad \ldots \quad (Ex. \ 3)$$

As a result, because the saturated current is large, there is a possibility that the short circuit of Type II and the short circuit of Type III requiring fast protection cannot be protected.

On the other hand, the gate voltage detection system can be classified into a mirror determination type compatible with the protection from the short circuit of Type I, and an overvoltage determination type compatible with the short circuit of Type II and the short circuit of Type III.

The gate voltage detection system of the mirror determination type detects that the gate voltage is kept constant in the mirror period in the normal turn-on state (FIG. 2A), but the gate voltage in the mirror period increases in the short circuit of Type I. Therefore, because the protection from the short circuit of Type I is assumed, the short circuit of Type II and the short circuit of Type III cannot be protected.

On the contrary, the gate voltage detection system of the overvoltage determination type detects that the gate-emitter voltage Vge increases more than a positive side supply voltage Vp. Since the gate voltage increases together with the short circuit by allowing a displacement current Is to flow from the collector into the gate according to (Ex. 1), the increase in the gate voltage can be detected. Accordingly, the gate voltage detection system of the overvoltage determination type is compatible with the protection from the short circuit of Type II and the protection from the short circuit of Type III. However, in the short circuit of Type I, because an increasing period of the gate voltage is shorter (FIG. 2B), there is a possibility that the gate voltage cannot be detected.

On the other hand, the gate current detection system detects a current flowing into the drive circuit side from the element according to (Ex. 1) by increasing the gate voltage to determine a negative current. Therefore, as in the overvoltage determination type of the gate voltage detection system, the gate current detection system is compatible with the protection from the short circuit of Type II and the protection from the short circuit of Type III, but may not detect the gate current because an occurrence period of the gate current is shorter in the short circuit of Type I.

In general, when the short circuit detecting means is used for a high-voltage inverter for use in railways, there is a possibility that a false detection caused by noise, that is, that short circuit is erroneously detected without the occurrence of the short circuit occurs to stop the inverter. On the contrary, a technique for monitoring the collector voltage and the gate voltage to prevent the false detection of the inverter is disclosed in JP-A-2007-259533.

This method conducts AND operation on a short circuit detection signal by the collector voltage and a short circuit detection signal by the gate voltage through an AND circuit, and determines a short circuit state on the basis of the output result.

In general, in the method of determining the short circuit on the basis of the output results of the AND operation of those two detection signals, the determination is reflected on the output result only when both of detector circuits detect the short circuit. Therefore, the false detection can be suppressed. That is, when it is assumed that one false detection probability is $\alpha$, and the other false detection probability is $\beta$, if those probabilities are independent from each other, the false detection probability $\gamma$ of the AND operation system becomes $\gamma=\alpha\beta$ ($\gamma<\alpha$ and $\gamma<\alpha$), and the false detection probability can be reduced. Also, if those detector circuits use different detection wirings, even if a larger noise is input to one of those detector circuits, the noise mixed into the other detector circuit is smaller, and a status in which the integrity of detection is enhanced as a whole is conceivable.

EP2458736 discloses a semiconductor element control device that controls a semiconductor element that performs switching operation for converting DC power into AC power, or AC power into DC power, that includes: a drive unit that outputs a drive signal for controlling the switching operation of the semiconductor element to a terminal of the semiconductor element; a short-circuit detection unit that detects short-circuit of the semiconductor element on the basis of the voltage at the terminal, and outputs a short-circuit detection signal; and a drive interruption unit that interrupts current flowing in the semiconductor element on the basis of the short-circuit detection signal output from the short-circuit detection unit.

WO2009/118201 discloses a method of operating an electronic valve in a converter, in particular a high power converter, wherein the valve comprises an electrically insulated control electrode and wherein the method comprises the steps: - an operating state of the converter and/or of the valve is/are monitored while the valve is open, - if the operating state fulfils a first pre-defined criterion, indicating that there is a short circuit which affects a current through the valve, a first process of de-charging the control electrode is performed in order to close the valve, - if the operating state fulfils a second pre-defined criterion, indicating that there may be a short circuit which affects a current through the valve, a second process of de-charging the control electrode is performed before the first criterion is fulfilled or is performed before the first process is started.

## SUMMARY OF THE INVENTION

However, the above AND operation system has an advantage that the false detection probability can be reduced, but suffers from at least the following problems.

First, there arises such a problem that when any one of two detecting means used in this system fails in the detection, the protection from the short circuit cannot be conducted.

For example, when the detection results of the emitter current detection system and the gate voltage detection (overvoltage determination type) system are ANDed in Table 1, there is a possibility that the short circuit of Type I cannot be detected.

Another problem resides in that even if one of the detection systems is high speed, if a detection delay of the other detection system is large, the detection delay of the AND operation system becomes large.

For example, in Table 1, if the emitter current detection system and the collector voltage detection system are used together, the collector voltage detection is larger in detection delay than the emitter current detection, and the advantage of the high speed property of the emitter current detection is not taken. This results in a possibility that the protection from the short circuit of Type II and the short circuit of Type III requiring the high speed cannot be conducted.

The present invention has been made in view of the above-mentioned problems, and therefore aims at providing a semiconductor drive device having a short circuit protection function that is compatible with all of the above three short circuit modes, and can suppress the occurrence of false detection, and a power conversion device using the semiconductor drive device.

According to a first aspect of the present invention there is provided a semiconductor drive device according to claim 1.

According to a second aspect of the present invention there is provided a semiconductor drive device according to claim 2.

Also, according to the present invention, there is provided a power conversion device according to claim 10.

According to the present invention, there can be realized the semiconductor drive device and the power conversion device, each having the short circuit protection function compatible with the short circuit of Type I, the short circuit of Type II, and the short circuit of Type III, and small in the false detection probability.

## BRIEF DESCRIPTION OF THE DRAWINGS

FIG. 1 is a block diagram illustrating a basic configuration of a general semiconductor drive device;
FIGS. 2A to 2D are schematic waveform diagrams of three short circuit modes classified according to a status in which short circuit is generated;
FIG. 3 is a block diagram illustrating a basic configuration of a semiconductor drive device according to a first embodiment of the present invention;
FIG. 4 is a block diagram illustrating a first specific example of a semiconductor drive device according to the first embodiment of the present invention;
FIG. 5 is a block diagram illustrating a second specific example of a semiconductor drive device according to the first embodiment of the present invention;
FIG. 6 is a block diagram illustrating a basic configuration of a semiconductor drive device according to a second embodiment of the present invention;
FIG. 7 is a block diagram illustrating a basic configuration of a semiconductor drive device according to a third embodiment of the present invention;
FIG. 8 is a block diagram illustrating a basic configuration of a semiconductor drive device according to a fourth embodiment of the present invention;
FIG. 9 is a block diagram illustrating a basic configuration of a semiconductor drive device according to a fifth embodiment of the present invention;
FIG. 10 is a block diagram illustrating a basic configuration of a semiconductor drive device according to a sixth embodiment of the present invention;

FIG. 11 is a block diagram illustrating a basic configuration of a semiconductor drive device according to a seventh embodiment of the present invention;

FIG. 12 is a block diagram illustrating a basic configuration of a semiconductor drive device according to an eighth embodiment of the present invention;

FIG. 13 is a block diagram illustrating a specific example of the semiconductor drive device according to the eighth embodiment of the present invention;

FIG. 14 is a block diagram illustrating a basic configuration of a semiconductor drive device according to a ninth embodiment of the present invention;

FIG. 15 is a block diagram illustrating a specific example of the semiconductor drive device according to the ninth embodiment of the present invention;

FIG. 16 is a block diagram illustrating a basic configuration of a semiconductor drive device according to a tenth embodiment of the present invention;

FIG. 17 is a block diagram illustrating a basic configuration of a semiconductor drive device according to an 11th embodiment of the present invention;

FIG. 18 is a block diagram illustrating a basic configuration of a semiconductor drive device according to a 12th embodiment of the present invention;

FIG. 19 is a block diagram illustrating a basic configuration of a semiconductor drive device according to a 13th embodiment of the present invention; and

FIG. 20 is a block diagram illustrating a basic configuration of a power conversion device according to a 14th embodiment of the present invention;

## DETAILED DESCRIPTION OF THE INVENTION

Hereinafter, first to 14th embodiments of the present invention will be described with reference to the accompanying drawings.

First Embodiment

(Configuration of Semiconductor Drive Device)

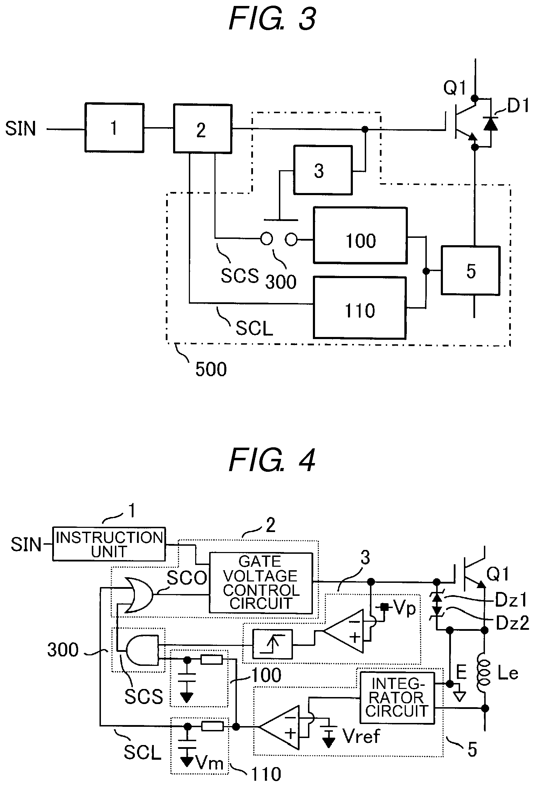

FIG. 3 is a block diagram illustrating a basic configuration of a semiconductor drive device according to a first embodiment of the present invention. In the first embodiment, an IGBT is exemplified as a semiconductor, but the present invention is not limited to this example, but can be applied to other general semiconductor drive devices.

As illustrated in FIG. 3, the semiconductor drive device according to the first embodiment includes a command unit 1, a gate drive unit 2, a gate voltage detection unit 3, a collector current detection unit 5, a first integration circuit 100, a second integration circuit 110, and an output control circuit 300.

Configuration examples of the collector current detection unit 5 generally correspond to a sense resistor, a sense element, and other current detectors.

The integration circuit 100 and the integration circuit 110 are circuits for integrating an output of the collector current detection unit 5, and the configuration example includes a filter circuit using passive elements such as a capacitor C and a resistor R, and a filter circuit using an operational amplifier. In this example, a time constant of the integration circuit 100 is shorter than a time constant of the integration circuit 110.

It is obvious that the semiconductor drive device according to the present invention can be applied to a case in which a large number of semiconductors which are basic configuration elements are provided.

(Operation of Semiconductor Drive Device)

When a drive command input signal SIN is input to the command unit 1 from a host logic unit, the command unit 1 processes a signal for preferably driving a semiconductor module having an IGBT Q1 and a diode D1 connected in reverse parallel to each other according to the drive command input signal SIN. As a result of this result, the gate drive unit 2 applies a voltage to a gate of the IGBT Q1, and controls the operation of the semiconductor module.

In this example, it is assumed that a pair of arm elements is destroyed into a short circuit state.

In this situation, as illustrated in FIG. 2, a gate voltage Vge of the IGBT Q1 increases, and a collector current Ic becomes in an overcurrent state. The collector current detection unit 5 that is a main detection unit detects an overcurrent of the collector current Ic. On the other hand, the gate voltage detection unit 3 that is an auxiliary detection unit detects an increase in the gate voltage Vge.

When the collector current detection unit 5 detects the overcurrent, a detection signal of the collector current detection unit 5 is input to the integration circuit 100 and the integration circuit 110. In this example, the integration circuit 100 and the integration circuit 110 each have a long or short time constant, and the time constant of the integration circuit 100 is set to be shorter than the time constant of the integration circuit 110. Each of the integration circuit 100 and the integration circuit 110 integrates the detection signal, and masks the detection signal smaller or shorter than a predetermined specified value.

In this example, when the gate voltage detection unit 3 does not detect an increase in the gate voltage Vge, the output control circuit 300 does not function. Therefore, the detection signal input to the gate drive unit 2 is only an output SCL of the integration circuit 110. Therefore, a detection signal SCL longer in time constant is input to the gate drive unit 2.

Conversely, when the gate voltage detection unit 3 detects an increase in the gate voltage Vge, the output control circuit 300 enables an output of the integration circuit 100, and the gate drive unit 2 receives both of an output SCL of the integration circuit 110 and an output SCS of the integration circuit 100.

Therefore, the gate drive unit 2 controls the gate so as to suppress the short circuit state of the semiconductor module according to the detection signal SCL longer in the time constant and the detection signal SCS shorter in the time constant.

That is, when a large current flows into the semiconductor module due to the short circuit of the semiconductor module, since a surge voltage attributable to Le·dIc/dt largely increases, there is a need to suppress the increase in the surge voltage with the provision of a protection circuit. Under the circumstances, there are conceivable, for example, a control under which a gate of an IGBT Q1 slowly turns off with an increase of RG (off), and a control in which a gate voltage is suppressed (since the collector current Ic has a proportional relationship with a gate-emitter voltage Vge, the short circuit current can be reduced by suppressing the Vge).

Also, a control mode can be changed according to the detection signal under such a control in which when the detection signal SCS is not input on the basis of two information of the detection signals SCL and SCS, the gate voltage of the IGBT Q1 is suppressed whereas when the detection signal SCS is input, the gate of the IGBT Q1 slowly turns off.

(Advantages obtained by First Embodiment)

According to the first embodiment of the present invention, since two detection systems using the gate voltage detection unit 3 and the collector current detection unit 5 are used, the detection signal SCS shorter in the time constant is input to the gate drive unit 2 only when both of the detection units function.

Therefore, the false detection rate can be suppressed as compared with a case in which the detection is conducted by only the collector current detection unit 5 at the same time constant as that of the detection signal SCS. This is the same advantage as that in the conventional AND operation system.

On the other hand, when the detection is not conducted by the gate voltage detection unit 3, because a single detection in the collector current detection unit 5 is conducted, the effect of suppressing the false detection rate with the above combination of the two systems cannot be expected. However, when the time constant of the integration circuit 110 is lengthened, since noise of a short time can be removed, the false detection rate can be suppressed.

Also, because the gate voltage detection unit 3 is used as the auxiliary detection unit for controlling the output of the integration circuit, the gate drive unit 2 can normally operate even if the gate voltage detection unit 3 conducts the false detection so long as the collector current detection unit 5 that is a main detection unit does not detect the overcurrent.

Subsequently, that a preferable protection from the above three short circuit modes can be realized according to the present invention will be described with reference to Table 1. As an example, it is assumed that the gate voltage detection unit 3 conducts the gate voltage detection of the overvoltage determination type, and the collector current detection unit 5 conducts the collector current detection.

First, when the short circuit of Type I occurs, there is a possibility that the gate voltage detection unit 3 cannot detect the abnormality because the increase in the gate voltage is insufficient, or in a short time. Therefore, the conventional AND operation system has a possibility that the detection is in failure. On the other hand, in the present invention, even when the gate voltage detection unit 3 does not detect the abnormality, the collector current detection unit 5 detects the overcurrent, and the detection signal SCL longer in the time constant is input to the gate drive unit 2.

This means that the element can be slowly and surely protected while the false detection rate is suppressed by lengthening the time constant. As described above, this uses that a short circuit capability of about 10μs of the element can be expected for the short circuit of Type I.

On the other hand, in the short circuit of Type II and the short circuit of Type III, because it can be expected that both of the gate voltage detection unit 3 and the collector current detection unit 5 conduct fast detection, the detection signal SCS shorter in the time constant is input to the gate drive unit 2.

This means that the element can be protected at high speed while the false detection rate is reduced by the combination of the two systems. That is, as described above, this is made in view of a fact that the fast protection is required against the short circuit of Type II and the short circuit of Type III.

As described above, the first embodiment of the present invention is to provide a preferable overcurrent protection that can realize the suppression of the false detection rate, taking the features of the above three short circuit modes into account.

<Specific Example 1 of First Embodiment>

FIG. 4 is a diagram illustrating a device configuration of a specific example 1 of the first embodiment illustrated in FIG. 3.

The gate voltage detection unit 3 is configured to detect a gate voltage higher than a supply voltage by a comparator, and generates a pulse for a given period upon detecting abnormality.

On the other hand, the collector current detection unit 5 integrates an electromotive voltage Le·dIc/dt generated in a parasitic inductance Le of the module to acquire a collector current, and determines an overcurrent state that is higher than a predetermined specified value by a comparator circuit.

The integration circuit 100 and the integration circuit 110 are each configured by a CR filter circuit. The output control circuit 300 is configured by an AND circuit, and enables the detection signal SCS shorter in the time constant which is an output of the integration circuit 100 when the gate voltage detection unit 3 detects the abnormality.

The gate drive unit 2 receives an OR operation result SCO of the detection signal SCL and the detection signal SCS, and the drive command input signal SIN through the command unit 1. If only the detection signal SCL occurs, the OR operation result SCO becomes the detection signal SCL. On the other hand, if the detection signal SCS is generated previously, the OR operation result SCO is equivalent to the detection signal SCS.

<Specific Example 2 of First Embodiment>

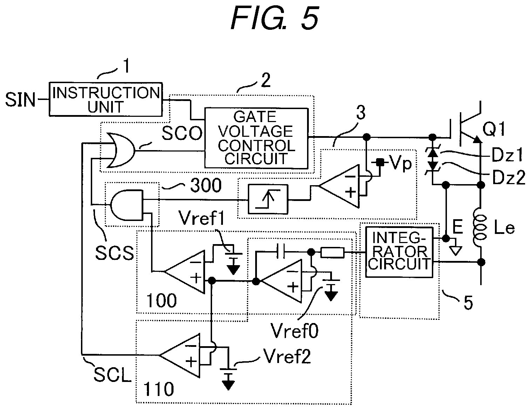

FIG. 5 is a diagram illustrating a device configuration of a specific example 2 of the first embodiment illustrated in FIG. 3.

A difference from the specific example 1 illustrated in FIG. 4 resides in that operational amplifiers are used as the integration circuit 100 and the integration circuit 110 to acquire a charge amount $\int dt \cdot Ic$ flowing in the element in the short circuit state.

With the above configuration, as compared with the time integration system using the CR filter circuits as in the specific example 1, since a determination level corresponding to a stress of acquiring how much charge amount flows, and accumulating the charge amount can be set, a robust design based on a load exerted on the element can be conducted.

Second Embodiment

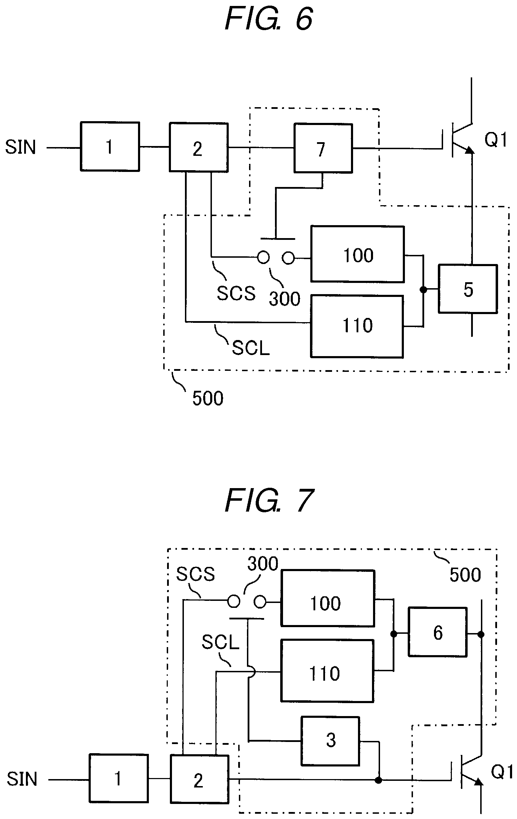

FIG. 6 is a diagram illustrating a basic configuration of a semiconductor drive device according to a second embodiment of the present invention.

A difference from the first embodiment illustrated in FIG. 3 resides in that a gate current detection unit 7 is used as the auxiliary detection unit, and a current flowing in the gate in the short circuit state is determined. The other configurations are identical with those in the first embodiment.

According to the second embodiment, the gate current when the element is destroyed can be detected, and the gate current detection unit 7 actually detects a voltage between both ends of a gate resistor Rg, and therefore is resistant to noise.

Third Embodiment

FIG. 7 is a diagram illustrating a basic configuration of a semiconductor drive device according to a third embodiment of the present invention.

A difference from the first embodiment illustrated in FIG. 3 resides in that, as the main detection unit, a collector voltage detection unit 6 determines a state in which the collector voltage in the short circuit state is high. The other configurations are identical with those in the first embodiment.

In the collector voltage detection type of the third embodiment, a real circuit configuration is simple, but there is a difficulty that the response is slow.

Fourth Embodiment

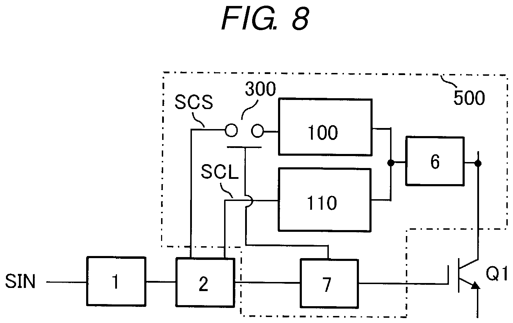

FIG. 8 is a diagram illustrating a basic configuration of a semiconductor drive device according to a fourth embodiment of the present invention.

A difference from the third embodiment illustrated in FIG. 7 resides in that, as the auxiliary detection unit, the gate current detection unit 7 determines a current that flows into the gate in the short circuit state. The other configurations are identical with those in the third embodiment.

The fourth embodiment has a feature obtained in the second embodiment as compared with the third embodiment.

Fifth Embodiment

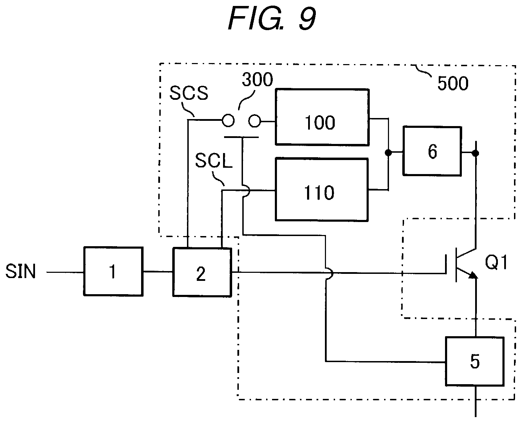

FIG. 9 is a diagram illustrating a basic configuration of a semiconductor drive device according to a fifth embodiment of the present invention.

A difference from the third embodiment illustrated in FIG. 7 resides in that, as the auxiliary detection unit, the collector current detection unit 5 determines an overcurrent of the collector current in the short circuit state. The other configurations are identical with those in the third embodiment.

In the fifth embodiment, since a main voltage (collector-emitter voltage Vce) and the main current (collector current Ic) of the element are directly detected. Therefore, a magnitude relationship between Vce and Ic conflict with each other in the normal state (Vce is large and Ic is small, or Vce is small and Ic is large). On the contrary, in the short circuit state, both of Vce and Ic become large, that is, abnormal, and the short circuit state is directly detected.

Sixth Embodiment

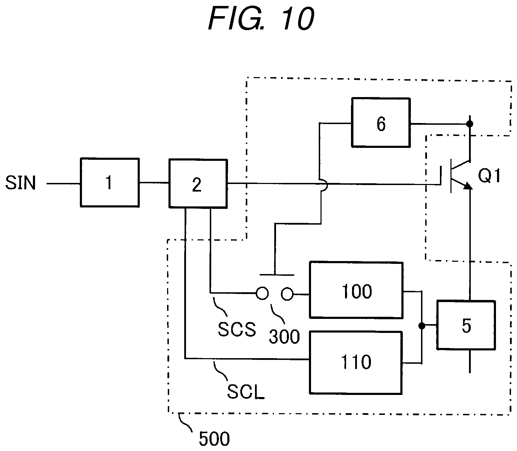

FIG. 10 is a diagram illustrating a basic configuration of a semiconductor drive device according to a sixth embodiment of the present invention.

A difference from the fifth embodiment illustrated in FIG. 9 resides in that the auxiliary detection unit and the main detection unit are replaced with each other. The other configurations are identical with those in the third embodiment.

In the sixth embodiment, the response is faster than that in the fifth embodiment.

Seventh Embodiment

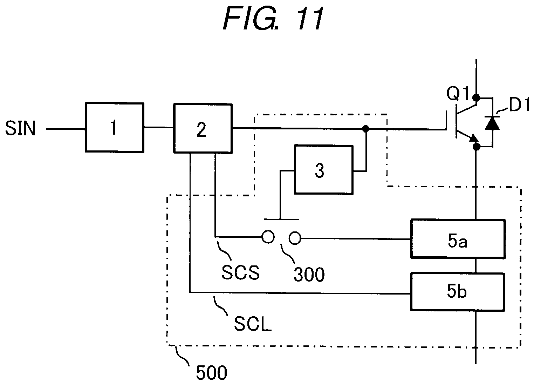

FIG. 11 is a diagram illustrating a basic configuration of a semiconductor drive device according to a seventh embodiment of the present invention.

A difference from the first embodiment illustrated in FIG. 3 resides in that two main detection units (5a and 5b) are provided, and have detection levels different from each other for detection. For example, a case in which two different levels are provided as Vref of the operational amplifier in the collector current detection unit 5 described in the specific example 1 (FIG. 4) of the first embodiment, and a case in which the operational amplifiers to be used are intended for high frequency and low frequency are assumed. The output control circuit 300 directly controls an output of the lower detection level (5a) of the two main detection units so as to be responsive to an increase in the gate voltage. The other configurations are identical with those in the first embodiment.

Eighth Embodiment

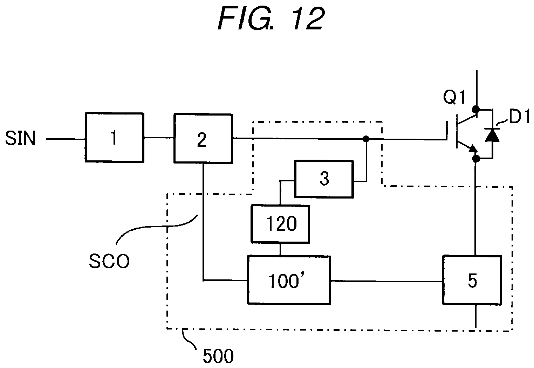

FIG. 12 is a diagram illustrating a basic configuration of a semiconductor drive device according to an eighth embodiment of the present invention.

A difference from the first embodiment illustrated in FIG. 3 resides in that a time constant of a time constant regulation integration circuit 100' is controlled through a time constant switching circuit 120 instead of the output control circuit 300 controlling the output of the integration circuit. The time constant switching circuit 120 is configured in such a manner that, for example, capacitors of the integration circuits 100 and 101 illustrated in the specific example 1 (FIG. 4) of the first embodiment are disposed in parallel, a switch unit is connected in series with one of the capacitors. The other configurations are identical with those in the first embodiment.

<Specific Example of Eighth Embodiment>

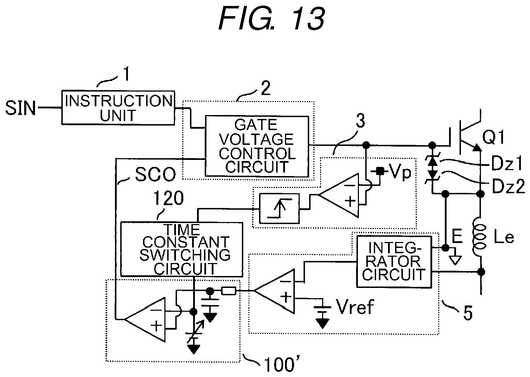

FIG. 13 is a diagram illustrating a specific example of the semiconductor drive device according to the eighth embodiment of the present invention.

In the eighth embodiment illustrated in FIG. 12, the time constant regulation integration circuit 100' includes a given CR filter, and a determination level regulation comparator circuit, and regulates the determination level of the comparator circuit according to the output of the time constant switching circuit 120. If the gate voltage increases to a given level or higher, the determination level is lowered to respond quickly.

Ninth Embodiment

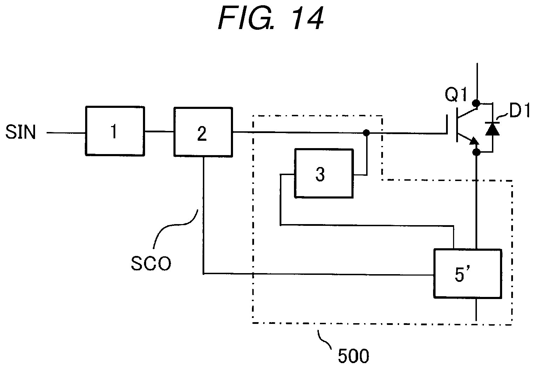

FIG. 14 is a diagram illustrating a basic configuration of a semiconductor drive device according to a ninth embodiment of the present invention.

A difference from the seventh embodiment illustrated in FIG. 11 resides in that the detection level of one main detection unit (collector current detection unit 5') switches according to an output of the auxiliary detection unit (gate voltage detection unit 3) instead of the provision of the two main detection units. The other configurations are identical with those in the first embodiment.

<Specific Example of Ninth Embodiment>

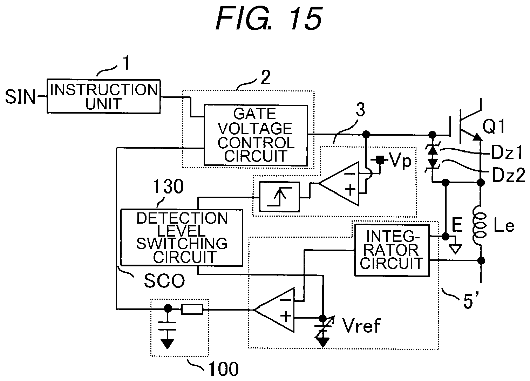

FIG. 15 is a diagram illustrating a specific example of the semiconductor drive device according to the ninth embodiment of the present invention.

In the collector current detection unit 5' according to the ninth embodiment illustrated in FIG. 14, the electromotive voltage Le·dIc/dt generated in the module parasitic inductance Le is integrated to acquire the collector current, and in determining the overcurrent state by the comparator circuit, the determination level of the comparator circuit is switched by a detection level switching circuit 130 that receives an output of the auxiliary detection unit (gate voltage detection unit 3). In the circuit configuration of FIG. 14, when the gate voltage increases to a given level or higher, Vref of the comparator in the collector current detection unit 5' increases to be intended to achieve a quick response. This is compatible with a case in which the detection level on a blink is set. Tenth Embodiment

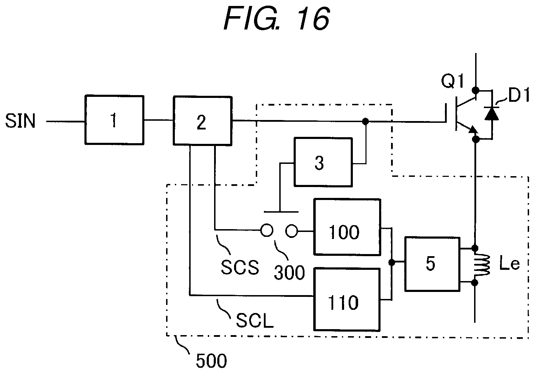

FIG. 16 is a diagram illustrating a basic configuration of a semiconductor drive device according to a tenth embodiment of the present invention.

A difference from the first embodiment illustrated in FIG. 3 resides in that as the main detection unit, not the current sensor, but the electrostatic voltage Le·dIc/dt (that is, a differential value of the collector current) generated between the terminals of the module parasitic inductance Le is used. The other configurations are identical with those in the first embodiment.

Eleventh Embodiment

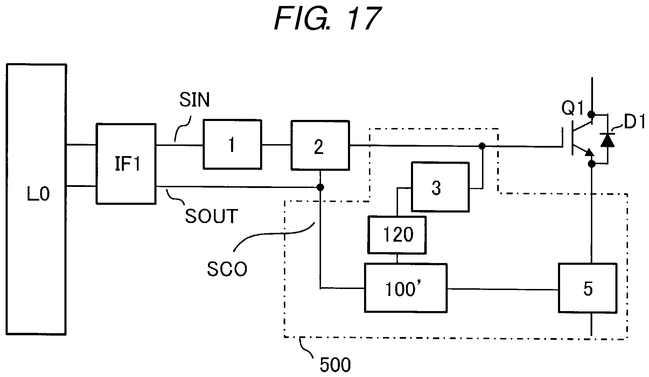

FIG. 17 is a diagram illustrating a basic configuration of a semiconductor drive device according to an eleventh embodiment of the present invention.

In the eighth embodiment illustrated in FIG. 12, an output signal SCO of the time constant regulation integration circuit 100' is transmitted to the host logic unit through an insulating interface circuit IF1 (feedback signal SOUT). The other configurations are identical with those in the first embodiment. With the above configuration, a short circuit event can be transmitted directly to the host logic unit.

Twelfth Embodiment

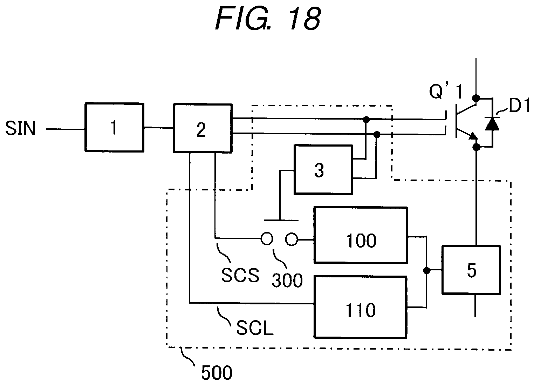

FIG. 18 is a diagram illustrating a basic configuration of a semiconductor drive device according to a twelfth embodiment of the present invention.

A difference from the first embodiment illustrated in FIG. 3 resides in that the semiconductor to be driven is a double gate semiconductor switching element (for example, double gate IGBT) having two control terminals. As a result, the gate drive unit 2 controls the respective control terminals on the basis of two information of the detection signal SCL and the detection signal SCS, independently. The other configurations are identical with those in the first embodiment. As a result, a function of turning off one of the control terminals to suppress the gate can be added to the semiconductor drive device.

Thirteenth Embodiment

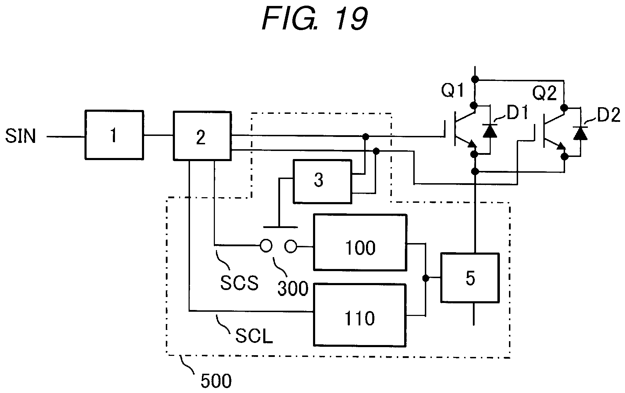

FIG. 19 is a diagram illustrating a basic configuration of a semiconductor drive device according to a thirteenth embodiment of the present invention.

A difference from the first embodiment illustrated in FIG. 3 resides in that plural semiconductors to be driven are connected in parallel to each other. As a result, the gate drive unit 2 controls the control terminals of the respective semiconductors on the basis of two information of the detection signal SCL and the detection signal SCS, independently. The other configurations are identical with those in the first embodiment. As a result, the present invention is also compatible with a configuration intended for larger energization current.

Fourteenth Embodiment

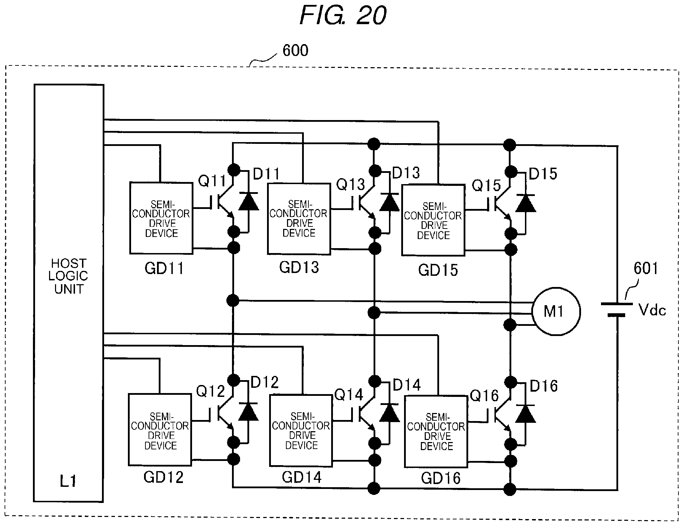

FIG. 20 is a diagram illustrating a power conversion device applied with a semiconductor drive device according to a fourteenth embodiment of the present invention.

In the power conversion device according to the fourteenth embodiment, the semiconductor drive device according to any one of the above first embodiment to the thirteenth embodiment is applied to a drive device of the semiconductor switching element in the power conversion device.

As illustrated in FIG. 20, a power conversion device 600 according to the fourteenth embodiment includes a host logic unit L1 that generates a drive command signal which is a control signal of the switching operation to semiconductor switching elements Q11 to Q16, diodes D11 to D16, semiconductor drive devices GD11 to GD16, and semiconductor switching elements Q11 to Q16. The power conversion device 600 according to the fourteenth embodiment is an inverter device that converts a DC power of a DC power supply 601 with a voltage Vdc into an AC power.

Also, in the fourteenth embodiment, IGBTs are used as the semiconductor switching elements Q11 to Q16. However, the present invention is not limited to this configuration, but can be configured by other switching elements such as MOSFET.

The power conversion device 600 has three pairs of upper and lower arms connected between positive and negative terminals of the DC power supply 601 in which two semiconductor switching elements (Q11 and Q12, Q13 and Q14, and Q15 and Q16) are uniformed in polarity, and connected in series to each other. Also, the diodes D11 to D16 for circulating a load current are connected in parallel with reverse polarity between the emitter and the collector of the respective semiconductor switching elements Q11 to Q16. Also, the gate terminals of the respective semiconductor switching elements Q11 to Q16 are connected with the semiconductor drive devices GD11 to GD16 that output a drive command signal of switching, respectively. Also, a connection point of each two semiconductor switching elements (Q11 and Q12, Q13 and Q14, Q15 and Q16) connected in series is an AC output terminal, and connected to a three-phase AC motor M1 which is a load.

The power conversion device 600 controls the switching operation of the respective semiconductor switching elements Q11 to Q16 through the semiconductor drive devices GD11 to GD16 by the host logic unit L1, and supplies an AC power to a three-phase AC motor M1 connected to the AC terminal.

In this example, the power conversion device 600 generates the drive command signals to the respective semiconductor switching elements Q11 to Q16 by the host logic unit L1, and transmits the drive command signals to the gate terminals (control terminals) of the semiconductor switching elements Q11 to Q16, respectively, through the semiconductor drive devices GD11 to GD16 to conduct the power conversion operation. In this situation, because the power conversion device 600 transmits the drive command signals from the semiconductor drive devices GD11 to GD16 through an insulation communication, an influence of noise generated in the switching operation of the semiconductor switching elements Q11 to Q16 is reduced. For that reason, the power conversion device 600 can conduct power conversion with high reliability.

In the fourteenth embodiment, the inverter device has been described as an example in which the semiconductor drive device according to the present invention is applied to the power conversion device. However, the present invention is not limited to this configuration, but can be applied to another power conversion device such as a DC/DC converter or an AC/DC converter.


**Claims**

1.  A semiconductor drive device, comprising:

    a semiconductor element (Q1) having a pair of main terminals (C, E), and a control terminal (G) arranged to control a current flowing in the main terminal pair (C, E);
    a main detection unit (5, 5a, 5b, 6) arranged to detect a current or a voltage in the main terminals (C, E);
    an auxiliary detection unit (3, 5, 7) arranged to detect any one of a current or a voltage of the control terminal (G), or a current or a voltage of the main terminals (C, E) which is not detected by the main detection unit (5, 5a, 5b, 6); and
    an integration unit (100, 110) arranged to receive an output of the main detection unit (5, 5a, 5b, 6);
    **characterized in that**:

    the integration unit (100, 110) is arranged to conduct two time integrations different in time constant;
    the semiconductor drive device comprises an output control unit (300) arranged to control an output from the integration unit (100) which is shorter in the time constant according to an output of the auxiliary detection unit (3, 5, 7), and

the voltage or the current of the control terminal (G) is controllable according to the result (SCO) of a logical OR operation performed on an output (SCL) of the integration unit (110) which is longer in the time constant and an output (SCS) of the output control unit (300).

2. A semiconductor drive device, comprising:

a semiconductor element (Q1) having a pair of main terminals (C, E), and a control terminal (G) arranged to control a current flowing in the main terminal pair (C, E);
a main detection unit (5, 5') arranged to detect a current or a voltage in the main terminals (C, E);
an auxiliary detection unit (3) arranged to detect any one of a current or a voltage of the control terminal (G), or a current or a voltage of the main terminals (C, E) which is not detected by the main detection unit (5, 5'); and
an integration unit (100, 100') arranged to integrate an output of the main detection unit (5, 5') with time;
**characterized in that**:

the semiconductor drive device comprises a switching unit (120, 130) arranged to switch a detection level of the main detection unit (5') or a time constant of the integration unit (100') according to an output of the auxiliary detection unit (3), and
the voltage or the current of the control terminal (G) is controllable according to the output of the integration unit (100, 100') through the switching unit (120, 130).

3. The semiconductor drive device according to claim 1 or 2,
wherein the integration unit (100, 100', 110) includes a filter circuit using a passive element or an operational amplifier.

4. The semiconductor drive device according to any one of claims 1 to 3,
wherein the main detection unit (5, 5', 5a, 5b) is arranged to obtain the current of the main terminals (C, E), by integrating an electromotive voltage generated in a parasitic inductance (Le) of the semiconductor element (Q1), when the main detection unit (5, 5', 5a, 5b) detects the current.

5. The semiconductor drive device according to any one of claims 1 to 3,
wherein an electromotive voltage generated in a parasitic inductance (Le) of the semiconductor element (Q1) is applicable as a differential value of the current of the main terminals(C, E) instead of the current of the main terminals (C, E) which is detected by the main detection unit (5, 5').

6. The semiconductor drive device according to any one of claims 1 to 5,
wherein the semiconductor drive device comprises a logic unit (2) arranged to output a drive command to the control terminal (G), and wherein the logic unit (2) is arranged to receive transmission of an output (SCL) from the integration unit (110) which is longer in time constant, or an output (SCS) of the output control unit (300).

7. The semiconductor drive device according to any one of claims 1 to 6,
wherein a voltage or a current of the control terminal (G) is reducible when the semiconductor element (Q1) is in an on-state involved in a short circuit state.

8. The semiconductor drive device according to any one of claims 1 to 7,
wherein the control terminal (G) of the semiconductor element (Q1) comprises a plurality of control terminals, and voltages or currents of the plurality of control terminals are independently controllable.

9. The semiconductor drive device according to claim 6,
wherein the semiconductor element (Q1) controlled according to the drive command comprises a plurality of semiconductor elements (Q11-Q16) connected in parallel, and the respective control terminals of the plurality of semiconductor elements (Q11-Q16) are independently controllable.

10. A power conversion device including a plurality of upper and lower arms having a plurality of semiconductor switching elements connected in series, and a plurality of semiconductor drive devices arranged to control on/off operation of each of the plurality of semiconductor switching elements,
wherein the plurality of semiconductor drive devices comprises the semiconductor drive device according to any one of claims 1 to 9.

**Patentansprüche**

1. Halbleiterantriebsvorrichtung, umfassend:

   ein Halbleiterelement (Q1) mit einem Paar von Hauptanschlüssen (C, E) und einem Steuerungsanschluss (G), der dazu ausgelegt ist, einen in dem Paar von Hauptanschlüssen (C, E) fließenden Strom zu steuern;
   eine Hauptdetektionseinheit (5, 5a, 5b, 6), die dazu ausgelegt ist, einen Strom oder eine Spannung in den Hauptanschlüssen (C, E) zu detektieren;
   eine Hilfsdetektionseinheit (3, 5, 7), die dazu ausgelegt ist, einen Strom oder eine Spannung des Steuerungsanschlusses (G), oder einen Strom oder eine Spannung der Hauptanschlüsse (C, E) der bzw. die von der Hauptdetektionseinheit (5, 5a, 5b, 6) nicht detektiert worden ist, zu detektieren; und
   eine Integrationseinheit (100, 110), die dazu ausgelegt ist, eine Ausgabe der Hauptdetektionseinheit (5, 5a, 5b, 6) zu detektieren;
   **gekennzeichnet dadurch, dass**:

   die Integrationseinheit (100, 110) dazu ausgelegt ist, zwei in Zeitkonstanten verschiedene Zeitintegrationen durchzuführen;
   die Halbleiterantriebsvorrichtung eine Ausgabesteuereinheit (300) umfasst, die dazu ausgelegt ist, eine Ausgabe von der Integrationseinheit (100), die in der Zeitkonstante kürzer ist, gemäß einer Ausgabe der Hilfsdetektionseinheit (3, 5, 7) zu steuern, und
   die Spannung oder der Strom des Steuerungsanschlusses (G) entsprechend dem Ergebnis (SCO) einer logischen OR-Operation steuerbar ist, die auf eine Ausgabe (SCL) der Integrationseinheit (110), die in der Zeitkonstante länger ist, und eine Ausgabe (SCS) der Ausgabesteuereinheit (300) angewendet wird.

2. Halbleiterantriebsvorrichtung, umfassend:

   ein Halbleiterelement (Q1) mit einem Paar von Hauptanschlüssen (C, E) und einem Steuerungsanschluss (G), der dazu ausgelegt ist, einen in dem Paar von Hauptanschlüssen (C, E) fließenden Strom zu steuern;
   eine Hauptdetektionseinheit (5, 5'), die dazu ausgelegt ist, einen Strom oder eine Spannung in den Hauptanschlüssen (C, E) zu detektieren;
   eine Hilfsdetektionseinheit (3), die dazu ausgelegt ist, einen Strom oder eine Spannung des Steuerungsanschlusses (G), oder einen Strom oder eine Spannung der Hauptanschlüsse (C, E) der bzw. die von der Hauptdetektionseinheit (5, 5') nicht detektiert worden ist, zu detektieren; und
   eine Integrationseinheit (100, 100'), die dazu ausgelegt ist, eine Ausgabe der Hauptdetektionseinheit (5, 5') bezüglich der Zeit zu integrieren;
   **gekennzeichnet dadurch, dass**:

   die Halbleiterantriebsvorrichtung eine Schalteinheit (120, 130) umfasst, die dazu ausgelegt ist, ein Detektionsniveau der Hauptdetektionseinheit (5') oder eine Zeitkonstante der Integrationseinheit (100') gemäß einer Ausgabe der Hilfsdetektionseinheit (3) umzuschalten, und
   die Spannung oder der Strom des Steuerungsanschlusses (G) entsprechend der Ausgabe der Integrationseinheit (100, 100') über die Schalteinheit (120, 130) steuerbar ist.

3. Halbleiterantriebsvorrichtung nach Anspruch 1 oder 2,
   wobei die Integrationseinheit (100, 100', 110) eine Filterschaltung enthält, die ein passives Element oder einen Operationsverstärker verwendet.

4. Halbleiterantriebsvorrichtung nach einem der Ansprüche 1 bis 3,
   wobei die Hauptdetektionseinheit (5, 5', 5a, 5b) dazu ausgelegt ist, den Strom der Hauptanschlüsse (C, E) durch Integrieren einer in einer Parasitärinduktivität (Le) des Halbleiterelements (Q1) erzeugten elektromotorischen Spannung zu erhalten, wenn die Hauptdetektionseinheit (5, 5', 5a, 5b) den Strom detektiert.

5. Halbleiterantriebsvorrichtung nach einem der Ansprüche 1 bis 3,
   wobei eine in einer Parasitärinduktivität (Le) des Halbleiterelements (Q1) erzeugte elektromotorische Spannung als ein Differentialwert des Stroms der Hauptanschlüsse (C, E) anstatt des Stroms der Hauptanschlüsse (C, E), der von der Hauptdetektionseinheit (5, 5') detektiert wird, anwendbar ist.

6. Halbleiterantriebsvorrichtung nach einem der Ansprüche 1 bis 5,

wobei die Halbleiterantriebsvorrichtung eine Logikeinheit (2) umfasst, die dazu ausgelegt ist, eine Antriebsanweisung an den Steuerungsanschluss (G) auszugeben, und wobei die Logikeinheit (2) dazu ausgelegt ist, die Übertragung einer Ausgabe (SCL) von der Integrationseinheit (110), die in der Zeitkonstante länger ist, oder eine Ausgabe (SCS) der Ausgabesteuereinheit (300) zu empfangen.

**7.** Halbleiterantriebsvorrichtung nach einem der Ansprüche 1 bis 6,
wobei eine Spannung oder ein Strom des Steuerungsanschlusses (G) reduzierbar ist, wenn sich das Halbleiterelement (Q1) in einem bei einem Kurzschlusszustand auftretenden An-Zustand befindet.

**8.** Halbleiterantriebsvorrichtung nach einem der Ansprüche 1 bis 7,
wobei der Steuerunganschluss (G) des Halbleiterelements (Q1) mehrere Steuerungsanschlüsse umfasst und Spannungen oder Ströme der mehreren Steuerungsanschlüsse unabhängig voneinander steuerbar sind.

**9.** Halbleiterantriebsvorrichtung nach Anspruch 6,
wobei das gemäß der Antriebsanweisung gesteuerte Halbleiterelement (Q1) mehrere parallel zueinander geschaltete Halbleiterelemente (Q11-Q16) umfasst und die jeweiligen Steuerungsanschlüsse der mehreren Halbleiterelemente (Q11-Q16) unabhängig voneinander steuerbar sind.

**10.** Stromwandlungsvorrichtung, die mehrere obere und untere Arme mit mehreren in Reihe geschalteten Halbleiterschaltelementen und mehreren Halbleiterantriebsvorrichtungen, die dazu ausgelegt sind, An-/Aus-Operationen jedes der mehreren Halbleiterschaltelemente zu steuern, enthält,
wobei die mehreren Halbleiterantriebsvorrichtungen die Halbleiterantriebsvorrichtung nach einem der Ansprüche 1 bis 9 umfassen.

## Revendications

**1.** Dispositif de commande à semi-conducteur, comportant :

un élément semi-conducteur (Q1) ayant une paire de bornes principales (C, E), et une borne de commande (G) conçue pour commander un courant circulant dans la paire de bornes principales (C, E),
une unité de détection principale (5, 5a, 5b, 6) conçue pour détecter un courant ou une tension dans les bornes principales (C, E),
une unité de détection auxiliaire (3, 5, 7) conçue pour détecter un élément quelconque parmi un courant ou une tension de la borne de commande (G), ou un courant ou une tension des bornes principales (C, E) qui n'est pas détecté par l'unité de détection principale (5, 5a, 5b, 6), et
une unité d'intégration (100, 110) conçue pour recevoir une sortie de l'unité de détection principale (5, 5a, 5b, 6),
**caractérisé en ce que** :

l'unité d'intégration (100, 110) est conçue pour conduire deux intégrations temporelles différentes en termes de constante de temps,
le dispositif de commande à semi-conducteur comporte une unité de commande de sortie (300) conçue pour commander une sortie de l'unité d'intégration (100) qui est plus courte en termes de constante de temps en fonction d'une sortie de l'unité de détection auxiliaire (3, 5, 7), et
la tension ou l'intensité de la borne de commande (G) peut être commandée en fonction du résultat (SCO) d'une opération OU logique exécutée sur une sortie (SCL) de l'unité d'intégration (110) qui est plus longue en termes de constante de temps et une sortie (SCS) de l'unité de commande de sortie (300).

**2.** Dispositif de commande à semi-conducteur, comportant :

un élément à semi-conducteur (Q1) ayant une paire de bornes principales (C, E), et une borne de commande (G) conçue pour commander un courant circulant dans la paire de bornes principales (C, E),
une unité de détection principale (5, 5') conçue pour détecter un courant ou une tension dans les bornes principales (C, E),
une unité de détection auxiliaire (3) conçue pour détecter un élément quelconque parmi un courant ou une tension de la borne de commande (G), ou un courant ou une tension des bornes principales (C, E) qui n'est pas détecté par l'unité de détection principale (5, 5'), et
une unité d'intégration (100, 100') conçue pour intégrer une sortie de l'unité de détection principale (5, 5') avec le temps,
**caractérisé en ce que** :

le dispositif de commande à semi-conducteur comporte une unité de commutation (120, 130) conçue pour commuter un niveau de détection de l'unité de détection principale (5') ou une constante de temps de l'unité d'intégration (100') en fonction d'une sortie de l'unité de détection auxiliaire (3), et la tension ou le courant de la borne de commande (G) peut être commandé en fonction de la sortie de l'unité d'intégration (100, 100') à travers l'unité de commutation (120, 130).

3. Dispositif de commande à semi-conducteur selon la revendication 1 ou 2,
dans lequel l'unité d'intégration (100, 100', 110) inclut un circuit de filtrage utilisant un élément passif ou un amplificateur opérationnel.

4. Dispositif de commande à semi-conducteur selon l'une quelconque des revendications 1 à 3,
dans lequel l'unité de détection principale (5, 5', 5a, 5b) est conçue pour obtenir l'intensité des bornes principales (C, E), en intégrant une tension électromotrice générée dans une inductance parasite (Le) de l'élément semi-conducteur (Q1), lorsque l'unité de détection principale (5, 5', 5a, 5b) détecte le courant.

5. Dispositif de commande à semi-conducteur selon l'une quelconque des revendications 1 à 3,
dans lequel une tension électromotrice générée dans une inductance parasite (Le) de l'élément semi-conducteur (Q1) est applicable comme une valeur différentielle du courant des bornes principales (C, E) au lieu du courant des bornes principales (C, E) qui est détecté par l'unité de détection principale (5, 5').

6. Dispositif de commande à semi-conducteur selon l'une quelconque des revendications 1 à 5,
dans lequel le dispositif de commande à semi-conducteur comporte une unité logique (2) conçue pour délivrer en sortie une instruction de commande à la borne de commande (G), et dans lequel l'unité logique (2) est conçue pour recevoir la transmission d'une sortie (SCL) de l'unité d'intégration (110) qui est plus longue en constante de temps, ou une sortie (SCS) de l'unité de commande de sortie (300).

7. Dispositif de commande à semi-conducteur selon l'une quelconque des revendications 1 à 6,
dans lequel une tension ou un courant de la borne de commande (G) est réductible lorsque l'élément semi-conducteur (Q1) est dans un état passant impliqué dans un état de court-circuit.

8. Dispositif de commande à semi-conducteur selon l'une quelconque des revendications 1 à 7,
dans lequel la borne de commande (G) de l'élément semi-conducteur (Q1) comporte une pluralité de bornes de commande, et des tensions ou des courants de la pluralité de bornes de commande peuvent être commandés indépendamment.

9. Dispositif de commande à semi-conducteur selon la revendication 6,
dans lequel l'élément semi-conducteur (Q1) commandé en fonction de l'instruction de commande comporte une pluralité d'éléments semi-conducteurs (Q11 à Q16) connectés en parallèle, et les bornes de commande respectives de la pluralité d'éléments semi-conducteurs (Q11 à Q16) peuvent être commandées indépendamment.

10. Dispositif de conversion de puissance incluant une pluralité de bras supérieurs et inférieurs ayant une pluralité d'éléments de commutation à semi-conducteur connectés en série, et une pluralité de dispositifs de commande à semi-conducteur conçus pour commander une opération de mise à l'état passant/bloqué de chacun de la pluralité d'éléments de commutation à semi-conducteur,
dans lequel la pluralité de dispositifs de commande à semi-conducteur comporte le dispositif de commande à semi-conducteur selon l'une quelconque des revendications 1 à 9.

FIG. 1

*FIG. 2A*    *FIG. 2B*    *FIG. 2C*    *FIG. 2D*

TURN-OFF (NORMAL)    Type I SHORT-CIRCUITING    Type II SHORT-CIRCUITING    Type III SHORT-CIRCUITING

# FIG. 3

# FIG. 4

# FIG. 5

## FIG. 6

## FIG. 7

# FIG. 8

# FIG. 9

# FIG. 10

# FIG. 11

# FIG. 12

# FIG. 13

## FIG. 14

SIN

Q1

D1

1

2

SCO

3

5'

500

# FIG. 15

## FIG. 16

# FIG. 17

## FIG. 18

## FIG. 19

## FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007259533 A
- EP 2458736 A

- WO 2009118201 A

**Non-patent literature cited in the description**

- **JORG SCHUMANN et al.** Influence of the Gate Drive on the Short-Circuit Type II and Type III Behavior of HV-IGBT. *PCIM2010,* 709-714